# EUROPEAN PATENT SPECIFICATION

(11) **EP 0 702 402 B1**
(45) Date of publication and mention of the grant of the patent: **15.01.2003**
(21) Application number: 94830425.8
(22) Date of filing: 13.09.1994
(51) Int. Cl.: H01L 21/66

(54) **Manufacturing method for integrated circuits and semiconductor wafer so obtained**
Verfahren zur Herstellung integrierter Schaltungen und erzeugte Halbleiterscheibe
Procédé de fabrication pour des circuits intégrés et plaquette semi-conductrice ainsi obtenue

(43) Date of publication of application: 20.03.1996
(73) Proprietor: STMicroelectronics S.r.l., 20041 Agrate Brianza (Milano) (IT)
(72) Inventor: Murari, Bruno, I-20052 Monza (Milano) (IT); Toscani, Roberto, I-20155 Milano (IT); Marchio', Fabio, I-20018 Sedriano (Milano) (IT); Storti, Sandro, I-20099 Sesto S.Giovanni(Milano) (IT)
(74) Representative: Botti, Mario

(56) References cited:
- IBM TECHNICAL DISCLOSURE BULLETIN., vol.33, no.8, January 1991, NEW YORK US pages 1 - 2 'Wafer level test and burn-in'
- IBM TECHNICAL DISCLOSURE BULLETIN., vol.32, no.6B, November 1989, NEW YORK US pages 442 - 443 'Wafer burn-in isolation circuit'
- PATENT ABSTRACTS OF JAPAN vol. 17, no. 334 (E-1387) 24 June 1993 & JP-A-05 041 429 (NEC CORP.) 19 February 1993
- IBM TECHNICAL DISCLOSURE BULLETIN., vol.15, no.9, February 1973, NEW YORK US pages 2681 - 2682 R. BOVE ET AL. 'Impedance termination for AC testing monolithic chips'
- PATENT ABSTRACTS OF JAPAN vol. 14, no. 461 (E-0987) 5 October 1990 & JP-A-02 186 673 (NEC CORP.) 20 July 1990

## Description

### Field of application

The present invention relates to a manufacturing method for electronic circuits monolithically integrated on a semiconductor support on which said electronic circuits are regularly arranged side by side and separated by dividing grooves.

The present invention concerns also a semiconductor wafer incorporating a plurality of said electronic circuits.

### Known art

As known, the production process leading to the provision on a large scale of integrated electronic circuits comprises a plurality of processing steps which take place on a thin wafer of semiconductor, e.g. a so-called monocrystalline silicon wafer.

The wafer is subjected to a plurality of chemical and physical treatments and to photolithographic processes which lead to the definition of a complex three-dimensional topography constituting the integrated circuit architecture.

A single wafer can contain hundreds of identical integrated circuits commonly called chips and arranged regularly side by side and separated by scribing lines.

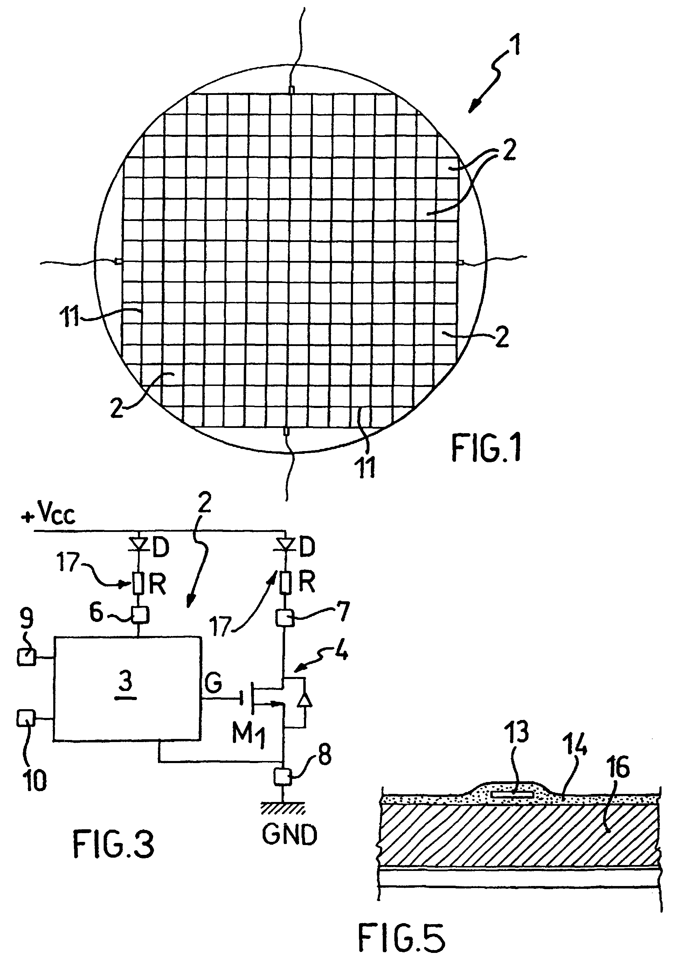

In the annexed FIG. 1 is shown schematically a top view of a wafer incorporating a so-called chip matrix.

The processing of a wafer ends with an electrical testing. Before the circuits are separated by sectioning the wafer each circuit is tested to check if it operates correctly.

Indeed, since it's impossible to avoid the presence of defects in the wafer, a certain percentage of circuits will exhibit defects or faults such as to compromise their correct operation.

Even a single defect can ruin an entire circuit, e.g. a scratch of a few micrometers or even a single grain of dust can break a connection.

The most common failure state afflicting the semiconductor chips is the presence of short circuits inside the integrated structure.

The electrical testing is performed automatically by a test machine managed by a computer which rapidly checks one circuit after the other and marks the defective ones to indicated that they are to be rejected.

It is not possible to repair the defective circuits which are to be rejected, otherwise they would be subjected uselessly to subsequent costly operations of assembly and encapsulation in packages.

A chip failure test at wafer level is described in the IBM Technical Disclosure Bulletin, vol. 33, no. 8 of January 1991, pages 1-2. This document disclose a wafer comprising a plurality of integrated circuits, regularly spaced apart by kerf regions, in which connection lines to the circuits are provided.

Also known from the IBM Technical Disclosure Bulletin, vol. 32, no. 6B of November 1989, pages 442-443 is a wafer isolation circuit, provided with diode and fuse linkage in order to permit total chip isolation prior to burn-in stressing of the wafer.

Finally, a semiconductor device provided with a protective circuitry, comprising a resistance and a diode, is described in the Patent Abstract of Japan, vol. 14, no. 461 & JP-A-02 186 673 of July 20, 1990.

From this point of view it is necessary to take into consideration another important aspect of these problems. Some chips are subject to a so-called 'infant mortality' phenomenon, i.e. they pass the operation test but cease to operate shortly after being put to use.

Even this type of failure, i.e. which takes place shortly after the first use of the circuits, is particularly harmful and a serious shortcoming for the manufacturer because the cost of additional inspection and encapsulation often exceeds the other production costs.

The technical problem underlying the present invention is to conceive a new manufacturing method for integrated electronic circuits having characteristics allowing easier, more economical and rapid identification of defective circuits during the electrical inspection step and overcoming the shortcomings which heretofore have limited the embodiments in accordance with the known art.

More specifically the technical problem is to conceive a manufacturing method which would allow identification and rejection also of those circuits which would be subject to 'infant mortality' and thus increase the quality of the entire final production.

### Summary of the invention

The solution idea underlying the present invention is to provide a network of electrical connection lines used for diagnosis in the wafer of semiconductor material on which are provided the circuits.

In this manner it is possible to simultaneously perform an electrical inspection of all the circuits present on the same wafer and detect the defective circuits, i.e. the short circuited integrated circuits.

The technical problem is solved by a method as defined in claim 1.

The technical problem is also solved by a wafer of semiconductor material as defined in claim 10.

The characteristics and advantages of the method in accordance with the present invention are set forth in the description of an embodiment thereof given below by way of non-limiting example with reference to a wafer of semiconductor material incorporating integrated electronic circuits and illustrated in the annexed drawings.

### Brief description of the drawings

In the drawings:
- FIG. 1 shows schematically a top view of a wafer or wafer of semiconductor material incorporating a plurality of integrated electronic circuits,

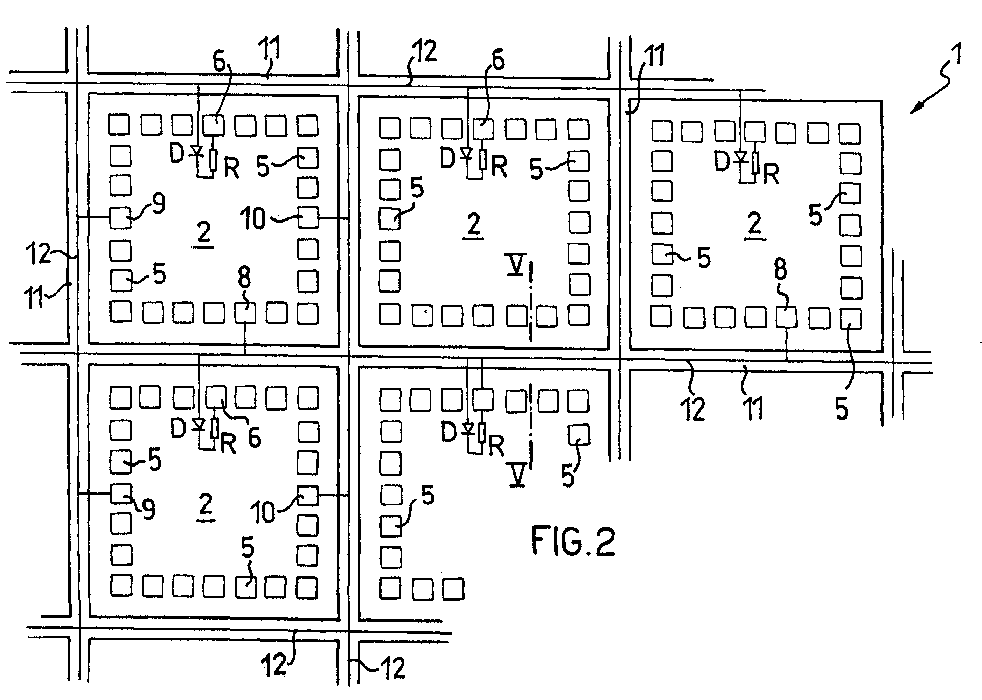

- FIG. 2 shows schematically in enlarged scale a group of integrated electronic circuits provided in accordance with the method of the present invention on the wafer of FIG. 1,
- FIG. 3 shows a detail of an electrical diagram of one of the integrated electronic circuits of FIG. 2,
- FIG. 4 shows schematically in even larger scale a detail of the group of integrated electronic circuits of FIG. 2, and
- FIG. 5 shows in enlarged scale and vertical cross section a detail of the wafer of FIG. 1 taken along plane of cut V-V of FIG. 2.

### Detailed description

With reference to the figures reference number 1 indicates as a whole and schematically a thin wafer of semiconductor material, e.g. a wafer of silicon on which have been provided multiple integrated circuits 2.

The integrated circuits 2 are essentially square or rectangular in shape with a few millimetres per side and can be digital, analog or power type.

The integrated circuits 2 are separated from each other by a groove 11, i.e. a dividing line of approximately 200 (m termed 'scribing line' and present between one chip and the next. The scribing line 11 completely surrounds each chip 2.

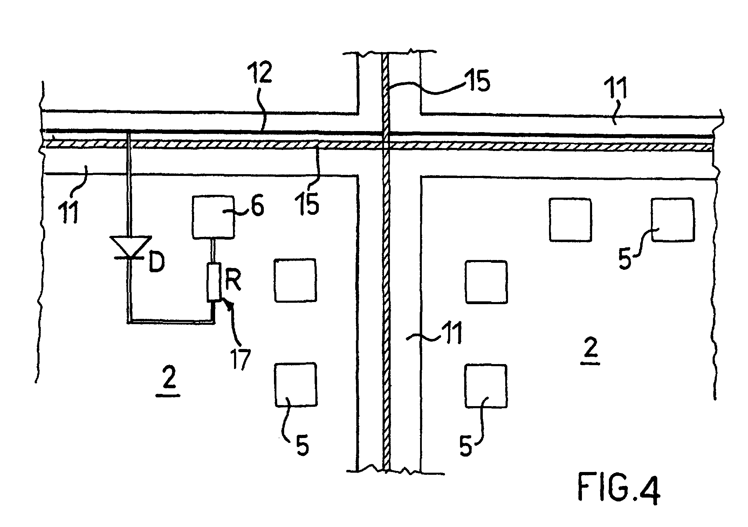

At the end of the production process leading to production and testing of the integrated circuits 2 the wafer is cut along the scribing line 11 by means of a very thin diamond blade which cuts along a cutting path nearly central and indicated by reference number 15 in FIG. 4.

In this manner the individual integrated circuits 2 are separated to be subjected to subsequent assembly operations in so-called packages, not shown because conventional.

Each integrated circuit 2 comprises a first control circuit portion indicated as a whole by reference number 3 and designed to operate at low supply voltage Vcc.

A second circuit portion 4 which we may term 'power' is in turn integrated in the circuit 2 in connection with the above portion 3. This second portion is designed to operate at a higher supply voltage Vd.

For the sake of simplicity of discussion the power circuit portion 4 has been diagrammed in FIG. 3 with a single power transistor M1 having a control terminal G connected to an output of the first portion 3. Of course said circuit portion 4 can be structured in a much more complex manner.

The transistor M1 can be e.g. the DMOS type and the integrated circuit 2 can be provided with BCD technology.

Every integrated circuit 2 comprises a plurality of terminals 5, called hereinafter 'pads', which are provided to allow electrical connection of the circuit to the associated connection pins during assembly in the supporting package once the circuit has been cut from the wafer.

A first pad 6 is provided to receive the low supply voltage Vcc of the control portion 3, a second pad 7 is provided to receive the supply voltage Vd of the power portion 4, a third pad 8 is designed for connection with another voltage reference, e.g. a signal ground GND.

The pads 6, 7 and 8 are powered with different voltages only when the circuit is placed in operating condition. In the greater part of cases the pads 6 and 7 are located near one side of the integrated circuit 2 opposite that near which is located the pad 8.

Additional pads 9 and 10 are provided to allow diagnostic operations, test1 and test2, as clarified below in the description. The pad 10 can coincide with the 'tristate' terminal present in many integrated circuits and is generally positioned on a side of the integrated circuit different from those on which are positioned pads 6, 7 and 8.

In accordance with the present invention inside and along the scribing lines 11 are provided connecting conducting lines 12. Specifically said connecting conducting lines 12 are metallisation strips 13 covered by a protective insulation layer 14, e.g. a layer of nitride or silicon oxide deposited by a P-Vapox process.

The protective insulation layer 14 insulates the metallisation strips 13 even from the surface of the semiconductor substrate 16.

The metallisation strips 13 extend inside the scribing lines parallel to their longitudinal axis X but in a slightly off-centre position in relation to said axis, e.g. as shown in FIG. 4.

The longitudinal axis X represents the cutting path 15 of the diamond blade used for separation of the integrated circuits 2.

The first pad 6 of the low supply voltage Vcc is electrically connected to the immediately adjacent connecting conducting line 12 by means of a current limitation element 17. Said current limitation element 17 comprises a resistance R and a protection diode D serially connected to the resistance.

Resistance R can be of approximately 10kohm or a current generator of adequate value can be used.

Normally the anode of the protection diode D is connected to the connecting conducting line 12. However, in CMOS circuits for which the semiconductor substrate is held at the low supply voltage +Vcc the previous connection must be reversed.

The second pad 7 of the supply voltage Vd is also electrically connected to said connecting conducting line 12 by means of the series of a resistance R and a protection diode D. The resistance can be e.g. approximately 10kohm.

All the pads 6 and 7 of the integrated circuits 2 incorporated in the wafer 1 are connected in the above stated manner to the connecting conducting line 12 located near them, i.e. to the connecting conducting line 12 of the scribing line 11 adjacent to them.

Both the protection diode D and the resistance R are provided by means of diffusion or an equivalent technique inside each integrated circuit 2.

Even the ground connection pads 8 are connected to a corresponding connecting conducting line 12 but this connection is the direct type and requires no protection diode. Normally the connecting conducting line 12 to which is connected the pad 8 is opposed to the connecting conducting line 12 to which are connected the pads 6 and 7, i.e. it belongs to a parallel scribing line 11.

The particular configuration of the wafer 1 which the semiconductor material assumes thanks to the present invention allows application of a particularly effective diagnostic procedure described below.

The purpose of this diagnostic procedure is to identify defective integrated circuits 2.

For this purpose the connecting conducting lines 12 are powered in such a manner as to activate in parallel all the integrated circuits 2. In this manner even the temperature is increased because due to the Joule effect the wafer containing hundreds of circuits dissipates electrical power in the form of heat.

It is well that this operational step be performed in an inert atmosphere, e.g. containing nitrogen.

In addition, by making use of the tristate pad 10 it is possible by means of a test point to extinguish the circuit in such a manner that only the defective circuits absorb electrical power, i.e. those in which there is an internal short circuit.

It has been calculated that current absorption of a defective chip is near 1mA.

Now if an integrated circuit is defective or exhibits a failure condition there is probably a short circuit in it which could connect the connecting conducting line 12 connected to the power supply pad 6 with the other connecting conducting line 12 connected to the ground pad 8.

However, in accordance with the present invention, this potential danger is avoided by the presence of the resistance R on the connection between the pads 6 and 7 and the connecting conducting line 12. Said resistance R limits the current passing through the short circuited integrated circuits 2.

The probability that a failure state might affect said resistance R is much lower than that of a failure of the integrated circuit 2 with which the resistance is associated.

Furthermore, the protection diode D in series with the resistance protects the circuit during operation calling for grounding.

This protection diode D continues to provide protection even when the integrated circuit 2 has been sectioned from the wafer 1. Attention is drawn to the example of FIG. 5 which shows the metallisation strip 13 sectioned vertically following cutting along the scribing line 11. The accessible edge of this metallisation strip 13 could constitute an electrical connection path to the substrate.

The presence of the protection diode D in the integrated circuit 2 also affords protection against this possible leakage to ground.

It is also noted that the characteristics of the present invention allow drastic reduction of the 'infant mortality' phenomenon of circuits already assembled because it is possible to determine failure states subsequent to the so-called zero time.

This purpose is attained by stressing with high temperature the gate oxide of the CMOS or DMOS devices incorporated in the integrated circuits 2. The quality of the DMOS is critical in the thin gate oxide.

The CMOS devices can be considered natural tristates since they do not absorb power when they are in an interdiction state. Nevertheless, they exhibit absorption peaks when they go into conduction.

In this context the pads 9 and 10 lend themselves effectively to this purpose because it is possible to apply a relatively slow synchronisation pulse (clock) on the pad 9 and an enablement signal upon starting on the pad 10. In this manner it is possible to cyclically switch the integrated circuit 2 from the starting state to that of extinguishment for a predetermined period of time, seeking to force a failure state which would have occurred only after a first employment of the circuit.

The above remarks make clear how the present invention solves effectively the technical problem and achieves numerous advantages the first of which is the fact that the manufacturing method in accordance with the present invention makes possible a burn-in of the wafer by stressing to a failure state all those circuits which would not have had a particularly long useful life.

## Claims

1. Method of monolithically manufacturing and testing integrated electronic circuits (2) on a semiconductor support (1) on which said integrated electronic circuits (2) are regularly spaced apart by scribing lines (11), each of said integrated electronic circuits comprising a control circuit (3) provided with a control circuit power supply pad (6) for powering said control circuit and a power circuit (4) provided with a power circuit power supply pad (7) for powering said power circuit, the method comprising the step of forming electrical power connection lines (12) in said scribing lines (11), said method further comprising, for each of said integrated electronic circuits, the step of:
- forming first and second unidirectional protection elements (D);
- electrically connecting each of said unidirectional protection elements to an electrical power connection line (12) immediately adjacent said integrated electronic circuit;
- forming a first resistive device (R) and electrically connecting it between said first unidirectional protection element (D) and said control circuit power supply pad (6) of said integrated electronic circuit (2);
- forming a second resistive device (R) and electrically connecting it between said second unidirectional protection element (D) and said power circuit power supply pad (7) of said integrated electronic circuit (2);
- powering said lines (12) such that a voltage is supplied via the respective unidirectional protection element and resistive device to the control circuit supply pad (6) and the power circuit power supply pad (7) of each of said integrated electronic circuits to activate in parallel all the integrated electronic circuits (2) for electrical inspection testing of the plurality of integrated electronic circuits (2).

2. Method in accordance with claim 1 **characterised in that** said electrical power connection lines (12) are metallisation strips (13) provided in said scribing lines (11).

3. Method in accordance with claim 1 **characterised in that** said first resistive device (R) is a 10kohm resistance.

4. Method in accordance with claim 1 **characterised in that** said first resistive device is a current generator.

5. Method in accordance with claim 3 **characterised in that** said resistance (R) is provided by diffusion technique in said integrated electronic circuits (2).

6. Method in accordance with claim 1 **characterised in that** said unidirectional protection elements are protection diodes (D).

7. Method in accordance with claim 6 **characterised in that** said protection diodes (D) are provided by diffusion in said integrated electronic circuits (2).

8. Method in accordance with claim 2 **characterised in that** it further comprises the step of covering said metallisation strips (13) by a protective insulation layer (14).

9. Method in accordance with claim 1 **characterised in that** it further comprises the step of connecting a first (9) and a second additional pad (10) of said integrated electronic circuits (2) to a synchronisation pulse and to an enablement signal, respectively, in order to allow a first and a second diagnostic operation, cyclically switching the integrated electronic circuits (2) from the starting state to that of extinguishment for a predetermined period of time, seeking to force a failure state which would have occurred only after a first employment of the circuit, so making possible a burn-in of the wafer by stressing to a failure state all those circuits which would not have had a particularly long useful life.

10. Wafer of semiconductor material (1) incorporating a plurality of electronic circuits (2) integrated monolithically on it and regularly spaced by scribing lines (11), electrical connection lines (12) being disposed within said scribing lines (11), each of said integrated electronic circuits comprising a control circuit (3) provided with a control circuit power pad (6) for powering said control circuit and a power circuit (4) provided with a power circuit power supply pad (7) for powering said power circuit, wherein there is provided for each integrated electronic circuit (2):
- first and second unidirectional protection elements (D), each of said first and second unidirectional protection elements being electrically connected to an electrical power connection line (12) immediately adjacent said integrated electronic circuit; and
- first and second resistive devices (R), the first resistive device (R) being electrically connected between said first unidirectional protection element (D) and said control circuit power supply pad (6) of said integrated electronic circuit, the second resistive device (R) being electrically connected between said second unidirectional protection element (D) and said power circuit power supply pad (7) of said integrated electronic circuit
such that a voltage may be supplied to the control circuit power supply pad (6) and the power circuit power supply pad (7) via the respective unidirectional protection element (D) and resistive device (R) by powering said electrical power connection lines (12) to thus activate all integrated electronic circuits (2) in parallel.

11. Wafer in accordance with claim 10 **characterised in that** said electrical connection lines (12) are metallisation strips (13) provided in said scribing line (11).

12. Wafer in accordance with claim 10 **characterised in that** said unidirectional protection element (D) is a diode.

13. Wafer in accordance with claim 10 **characterised in that** the unidirectional protection element (D) is polarised directly to the electrical connection line (12).

14. Wafer in accordance with claim 10 **characterised in that** the resistance (R) is at least 10kohm.

15. Wafer in accordance with claim 11 **characterised in that** said metallisation strips (13) are covered by a protective insulation layer (14).

16. Wafer in accordance with claim 10 **characterised in that** a first (9) and a second additional pad (10) of the integrated electronic circuits (2) are connected to a synchronisation pulse and to an enablement signal, respectively, in order to allow a first and a second diagnostic operation, cyclically switching on and off the integrated electronic circuits (2) for a predetermined period of time, seeking to force a failure state which would have occurred only after a first employment of the circuits, so making possible a burn-in of the wafer by stressing to a failure state all those circuits which would not have had a particularly long useful life.

## Patentansprüche

1. Verfahren zum monolithischen Herstellen und Testen integrierter elektronischer Schaltungen (2) auf einem Halbleitersubstrat (1), auf welchem die integrierten elektronischen Schaltungen (2) durch Ritzlinien (11) einen regelmäßigen Abstand voneinander haben, wobei jede der integrierten elektronischen Schaltungen eine Steuerschaltung (3), die mit einer Steuerschaltungsenergieversorgungskontaktfläche (6) für eine Energieversorgung der Steuerschaltung versehen ist, und eine Leistungsschaltung (4), die mit einer Leistungsschaltungsenergieversorgungskontaktfläche (7) für eine Leistungsversorgung der Leistungsschaltung versehen ist, aufweist, wobei das Verfahren den Schritt des Bildens elektrischer Energieverbindungsleitungen (12) in den Ritzlinien (11) aufweist und das Verfahren außerdem für jede der integrierten elektronischen Schaltungen folgenden Schritt aufweist:
- es werden erste und zweite unidirektionale Schutzelemente (D) gebildet;
- jedes der unidirektionalen Schutzelemente wird elektrisch mit einer elektrischen Energieversorgungverbindungsleitung (12) verbunden, die der integrierten elektronischen Schaltung unmittelbar benachbart ist;
- eine erste Widerstandsvorrichtung (R) wird gebildet und wird elektrisch zwischen das erste unidirektionale Schutzelement (D) und die Steuerschaltungsenergieversorgungskontaktfläche (6) der integrierten elektronischen Schaltung (2) geschaltet;
- eine zweite Widerstandsvorrichtung (R) wird gebildet und wird elektrisch zwischen das zweite unidirektionale Schutzelement (D) und die Leistungsschaltungsenergieversorgungskontaktfläche (7) der integrierten elektronischen Schaltung (2) geschaltet;
- die Leitungen (12 ) werden derart mit Energie versorgt, daß eine Spannung über das jeweilige unidirektionale Schutzelement und die Widerstandsvorrichtung zu der Steuerschaltungsenergieversorgungskontaktfläche (6) und zu der Leistungsschaltungsenergieversorgungskontaktfläche (7) einer jeden der integrierten elektronischen Schaltungen geliefert wird, um parallel alle diese integrierten elektronischen Schaltungen (2) für einen elektrischen Inspektionstest der Mehrzahl der integrierten Schaltungen (2) zu aktivieren.

2. Verfahren nach Anspruch 1, **dadurch gekennzeichnet, daß** die elektrischen Energieverbindungsleitungen (12) in den Ritzlinien vorgesehene Metallisierungsstreifen (13) sind.

3. Verfahren nach Anspruch 1, **dadurch gekennzeichnet, daß** die erste Widerstandsvorrichtung (R) ein Widerstand mit 10 KOhm ist.

4. Verfahren nach Anspruch 1, **dadurch gekennzeichnet, daß** die erste Widerstandsvorrichtung ein Stromgenerator ist.

5. Verfahren nach Anspruch 3, **dadurch gekennzeichnet, daß** der Widerstand (R) durch eine Diffusionsmethode in den integrierten elektronischen Schaltungen (2) vorgesehen wird.

6. Verfahren nach Anspruch 1, **dadurch gekennzeichnet, daß** die unidirektionalen Schutzelemente Schutzdioden (D) sind.

7. Verfahren nach Anspruch 6, **dadurch gekennzeichnet, daß** die Schutzdioden (D) durch Diffusion in die integrierten elektronischen Schaltungen (2) vorgesehen werden.

8. Verfahren nach Anspruch 2, **gekennzeichnet durch** den weiteren Schritt des Bedeckens der Metallisierungsstreifen (13) **durch** eine schützende IsolationsSchicht (14).

9. Verfahren nach Anspruch 1, **gekennzeichnet durch** den weiteren Schritt, daß eine erste (9) und eine zweite zusätzliche Kontaktfläche (10) der integrierten elektronischen Schaltungen (2) mit einem Synchronisationsimpuls bzw. mit einem Freigabesignal verbunden werden, um einen ersten und einen zweiten Diagnosebetrieb zu ermöglichen, wobei die integrierten elektronischen Schaltungen (2) zyklisch für eine vorbestimmte Zeitdauer von dem Startzustand zu dem Zustand des Löschens umgeschaltet werden, wobei versucht wird, einen Fehlerzustand zu erzwingen, der nur nach einer ersten Inbetriebnahme der Schaltung aufgetreten wäre, um so ein Einbrennen des Wafers **dadurch** möglich zu machen, daß alle diejenigen Schaltungen, die kein besonders langes Nutzleben gehabt hätten, beansprucht werden.

10. Wafer aus einem Halbleitermaterial (1), das eine Mehrzahl elektronischer Schaltungen (2) aufweist, die darauf monolithisch integriert und durch Ritzlinien (11) mit regelmäßigen Abständen versehen sind, wobei elektrische Verbindungsleitungen (12) innerhalb der Ritzenlinien (11) angeordnet sind und jede der integrierten elektronischen Schaltungen eine mit einer Steuerschaltungsenergieversorgungskontaktfläche (6) versehene Steuerschaltung (3) für eine Energieversorgung der Steuerschaltung und eine mit einer Leistungsschaltungsenergieversorgungskontaktfläche (7) versehene Leistungsschaltung (4) für eine Energieversorgung der Leistungsschaltung aufweist, wobei für jede integrierte elektronische Schaltung (2) vorgesehen sind:
- erste und zweite unidirektionale Schutzelemente (D), von denen jedes mit einer elektrischen Energieverbindungsleitung (12) verbunden ist, die der integrierten elektronischen Schaltung unmittelbar benachbart ist; und
- erste und zweite Widerstandsvorrichtungen (R), wobei die erste Widerstandsvorrichtung (R) elektrisch zwischen das erste unidirektionale Schutzelement (D) und die Steuerschaltungsenergieversorgungskontaktfläche (6) der integrierten elektronischen Schaltung geschaltet ist und die zweite Widerstandsvorrichtung (R) elektrisch zwischen das zweite unidirektionale Schutzelement (D) und die Leistungsschaltungsenergieversorgungsfläche (7) der elektronischen Schaltung geschaltet ist, derart, daß eine Spannung an die Steuerschaltungsenergieversorgungskontaktfläche (6) und die Leistungsschaltungsenergieversorgungskontaktfläche (7) über das jeweilige unidirektionale Schutzelement (D) und die Widerstandsvorrichtung (3) geliefert werden kann, indem die elektrischen Energieverbindungsleitungen (12) mit Energie beaufschlagt werden, um so alle integrierten elektronischen Schaltungen (2) parallel zu aktivieren.

11. Wafer nach Anspruch 10, **dadurch gekennzeichnet, daß** die elektrischen Verbindungsleitungen (12) Metallisierungsstreifen (13) sind, die in den Ritzlinien (11) vorgesehen sind.

12. Wafer nach Anspruch 10, **dadurch gekennzeichnet, daß** das unidirektionale Schutzelement (D) eine Diode ist.

13. Wafer nach Anspruch 10, **dadurch gekennzeichnet, daß** das unidirektionale Schutzelement (D) direkt auf die elektrische Verbindungsleitung (12) gepolt ist.

14. Wafer nach Anspruch 10, **dadurch gekennzeichnet, daß** der Widerstand wenigstens 10 KOhm beträgt.

15. Wafer nach Anspruch 11, **dadurch gekennzeichnet, daß** die Metallisierungsstreifen (13) von einer Schutzisolationsschicht (14) bedeckt sind.

16. Wafer nach Anspruch 10, **dadurch gekennzeichnet, daß** eine erste (9) und eine zweite zusätzliche Kontaktfläche (10) der integrierten elektronischen Schaltungen (2) mit einem Synchronisationsimpuls bzw. mit einem Freigabesignal verbunden sind, um einen ersten und einen zweiten Diagnosevorgang zu ermöglichen, wobei die integrierten elektronischen Schaltungen (2) für eine vorbestimmte Zeitdauer zyklisch geschaltet werden, um zu versuchen, einen Fehlerzustand zu forcieren, der nur nach einer ersten Benutzung der Schaltungen aufgetreten wäre, wodurch ein Einbrennen des Wafers dadurch möglich gemacht wird, daß alle diejenigen Schaltungen, die kein besonders langes Nutzungsleben hätten, unter Belastung gesetzt werden.

## Revendications

1. Procédé de fabrication monolithique et de test de circuits électroniques intégrés (2) sur un support semiconducteur (1) sur lequel ces circuits électroniques intégrés (2) sont espacés entre eux régulièrement par des lignes de rayure (11), chacun de ces circuits électroniques intégrés comprenant un circuit de commande (3) pourvu d'une plage d'alimentation de puissance du circuit de commande (6) pour alimenter ce circuit de commande et d'un circuit de puissance (4) pourvu d'une plage d'alimentation de puissance du circuit de puissance (7) pour alimenter ce circuit de puissance, le procédé comprenant l'étape de formation de ligne de liaison de puissance électrique (12) dans les lignes de rayure (11), ce procédé comprenant en outre, pour chacun des circuits électroniques intégrés, les étapes de :
- formation d'un premier et d'un second élément de protection unidirectionnel (D) ;
- liaison électrique de chacun de ces éléments de protection unidirectionnels à une ligne de liaison de puissance électrique (12) immédiatement adjacente au circuit électronique intégré ;
- formation d'un premier composant résistif (R) et liaison électrique de celui-ci entre le premier élément de protection unidirectionnel (D) et la plage d'alimentation de puissance du circuit de commande (6) du circuit électronique intégré (2) ;
- formation d'un second composant résistif (R) et liaison électrique de celui-ci entre le second élément de protection unidirectionnel (D) et la plage d'alimentation de puissance du circuit de puissance (7) du circuit électronique intégré (2) ;
- alimentation des lignes (12) de manière à appliquer une tension via l'élément de protection unidirectionnel respectif et le composant résistif à la plage d'alimentation du circuit de commande (6) et la plage d'alimentation de puissance du circuit de puissance (7) de chacun des circuits électroniques intégrés pour activer en parallèle tous les circuits électroniques intégrés (2) pour essai d'inspection électrique de la pluralité des circuits électroniques intégrés (2).

2. Procédé selon la revendication 1, **caractérisé en ce que** les lignes de liaison de puissance électrique (12) sont des bandes de métallisation (13) formées dans les lignes de rayure (11).

3. Procédé selon la revendication 1, **caractérisé en ce que** le premier composant résistif (R) est une résistance de 10 kilohms.

4. Procédé selon la revendication 1, **caractérisé en ce que** le premier composant résistif est un générateur de courant.

5. Procédé selon la revendication 3, **caractérisé en ce que** la résistance (R) est formée par une technique de diffusion dans les circuits électroniques intégrés (2).

6. Procédé selon la revendication 1, **caractérisé en ce que** les éléments de protection unidirectionnels sont des diodes de protection (D).

7. Procédé selon la revendication 6, **caractérisé en ce que** les diodes de protection (D) sont formés par diffusion dans les circuits électroniques intégrés (2).

8. Procédé selon la revendication 2, **caractérisé en ce qu'**il comprend également l'étape de couverture des bandes de métallisation (13) par une couche d'isolation protectrice (14).

9. Procédé selon la revendication 1, **caractérisé en ce qu'**il comprend en outre les étapes de liaison d'une première (9) et d'une seconde plage additionnelle (10) des circuits électroniques intégrés (2) à une impulsion de synchronisation et à un signal d'autorisation, respectivement, afin de permettre une première et une seconde opération de diagnostic, de commutation cyclique des circuits électroniques intégrés (2) depuis l'état de départ jusqu'à celui d'extinction pendant une période de temps prédéterminée, de tentative de forçage d'un état de défaut qui ne serait survenu qu'après un premier emploi du circuit, afin de rendre possible un déverminage de la tranche en contraignant à un état de défaut tout ceux des circuits qui n'auraient pas eu une durée de vie utile particulièrement longue.

10. Tranche de matériau semiconducteur (1) incorporant une pluralité de circuits électroniques (2) intégrés monolithiquement sur celle-ci et régulièrement espacés par des lignes de rayure (11), des lignes de liaison électriques (12) étant disposées dans ces lignes de rayure (11), chacun des circuits électroniques intégrés comprenant un circuit de commande (3) pourvu d'une plage d'alimentation de puissance du circuit de commande (6) pour alimenter ce circuit de commande et un circuit de commande (4) pourvu d'une plage d'alimentation en puissance du circuit de puissance (7) pour alimenter ce circuit de puissance, dans laquelle il est prévu pour chaque circuit électronique intégré (2) :
- un premier et un second élément de protection unidirectionnel (D), chacun de ces premiers et seconds éléments de protection unidirectionnels étant électriquement relié à une ligne de liaison de puissance électrique (12) immédiatement adjacente au circuit électronique intégré ; et
- un premier et un second composant résistif (R), le premier composant résistif (R) étant électriquement relié entre le premier élément de protection unidirectionnel (D) et la plage d'alimentation de puissance du circuit de commande (6) du circuit électronique intégré, le second composant résistif (R) étant électriquement relié entre le second élément de protection unidirectionnel (D) et la plage d'alimentation en puissance du circuit de puissance (7) du circuit électronique intégré, de sorte qu'une tension puisse être appliquée à la plage d'alimentation en puissance du circuit de commande (6) et à la plage d'alimentation en puissance du circuit de puissance (7) via l'élément de protection unidirectionnel (D) et le composant (R) respectifs, par alimentation des lignes de liaison de puissance électrique (12) afin d'activer ainsi en parallèle tous les circuits électroniques intégrés (2).

11. Tranche selon la revendication 10, **caractérisée en ce que** les lignes de liaison électrique (12) sont des bandes de métallisation (13) formées dans les lignes de rayure (11).

12. Tranche selon la revendication 10, **caractérisée en ce que** l'élément de protection unidirectionnel (D) est une diode.

13. Tranche selon la revendication 10, **caractérisée en ce que** l'élément de protection unidirectionnel (D) est directement polarisé sur la ligne de liaison électrique (12).

14. Tranche selon la revendication 10, **caractérisée ce que** la résistance (R) est d'au moins 10 kilohms.

15. Tranche selon la revendication 11, **caractérisée ce que** les bandes de métallisation (13) sont recouvertes d'une couche d'isolation protectrice (14).

16. Tranche selon la revendication 10, **caractérisée en ce qu'**une première (9) et une seconde (10) plage additionnelle des circuits électroniques intégrés (2) sont reliées à une impulsion de synchronisation et à un signal d'autorisation, respectivement, afin de permettre une première et une seconde opération de diagnostic, en commutant cycliquement en marche et en arrêt les circuits électroniques intégrés (2) pendant une période de temps prédéterminée, en tentant de forcer un état de défaut qui ne serait survenu qu'après un premier emploi des circuits, rendant ainsi possible un déverminage de la tranche en contraignant à un état de défaut tous ceux des circuits qui n'auraient pas eu une durée de vie utile particulièrement longue.
